(19) **Europäisches Patentamt**

**European Patent Office**

**Office européen des brevets**

(11) **EP 1 708 360 A1**

(12) **EUROPEAN PATENT APPLICATION**

(43) Date of publication:
04.10.2006 Bulletin 2006/40

(51) Int Cl.:
*H03F 1/32* (2006.01)

(21) Application number: 05006969.9

(22) Date of filing: 30.03.2005

| (84) Designated Contracting States:<br>AT BE BG CH CY CZ DE DK EE ES FI FR GB GR<br>HU IE IS IT LI LT LU MC NL PL PT RO SE SI SK TR<br>Designated Extension States:<br>AL BA HR LV MK YU | (71) Applicant: **SIEMENS AKTIENGESELLSCHAFT**<br>80333 München (DE)<br><br>(72) Inventor: **Langer, Andreas**<br>85716 Unterschleissheim-Lohhof (DE) |
| --- | --- |

(54) **Method and apparatus for generating a high frequency signal**

(57)     Method and apparatus for generating a high frequency signal (HFS) from a base band signal (BBS), the method improving the quality of the high frequency signal by compensation of nonlinearities that might occur during the generation of the high frequency signal, the method and apparatus comprising a digital control loop performed pre-distortion (PRED) of the base band signal. Preferably the pre-distortion of the base band signal is performed by a pre-distortion of the envelope of the base band signal together with a reconstruction of phase and amplitude of the base band signal by an adaptive digital filter (DF) and the high frequency output signal of a power amplifier (PA) is used to calculate the filter characteristic of the adaptive digital filter (DF).

List of Reference Symbols

PA
Power Amplifier
VGA
Pre-Amplifier

MIX
Mixer
MIX1, MIX2
Mixer 1, Mixer 2
DAC
Digital-to-Analog Converter
PRED
Pre-Distortion
DF
Digital Filter
CPCoupler
DEM
Demodulator
TRXF
Transmission Filter
FFT
Fast Fourier Transformation
FCP
Calculation of the Filter Characteristic

FIG 2

EP 1 708 360 A1

**Description**

In connection with modulation procedures with a non-constant (i.e. varying) envelope, e.g. HPSK as used in the UMTS-standard, usually a linear power amplifier is required to avoid nonlinear distortions of the envelope. Such nonlinear distortions among others lead to an increase in adjacent channel power, the so called "spectral re-growth". This is undesirable because other subscribers might be disturbed by spurious signals.

In various cellular communication standards precisely defined requirements have been defined for the maximally tolerable adjacent channel power. These requirements can frequently only be met with significant effort on the transmitter side.

The present invention therefore aims to contribute to a reduction of any increase of the adjacent channel power that may be caused be the nonlinear characteristics of real (i.e. non-ideal) power amplifiers used for the generation of a high frequency signal. This is achieved by a method and / or apparatus according to one of the claims.

In the following, the invention is disclosed in detail with reference to figures and by help of preferred embodiments.

Figure 1 shows a schematic model to illustrate the cancellation of nonlinearities according to the present invention.

Figure 2 shows a schematic illustration of an apparatus for generating a high frequency signal according to a preferred embodiment of the present invention.

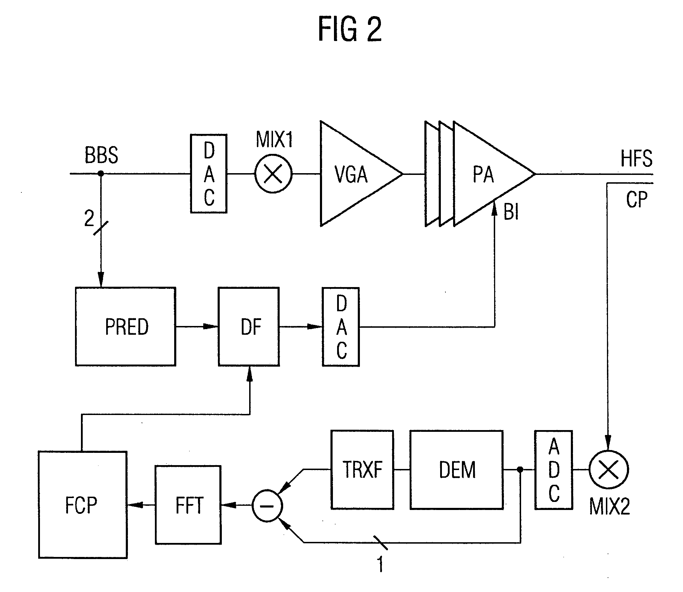

The present invention is based on the assumption that an apparatus for generating a high frequency signal is used that comprises a power amplifier (PA) with a bias input (BI) as shown in figure 2. This power amplifier receives an input signal from a pre-amplifier (VGA) and produces an output signal (HFS). The operation of the power amplifier (PA) is modified by the signal fed into the bias input (BI) in a way that is well known to the person skilled in the art.

A further assumption is that the (real, i.e. non-ideal) power amplifier (PA) operates with a not completely or exactly linear characteristic, but that there are non-negligible nonlinear contributions, that are regarded to be unavoidable to a certain extend in any real amplifier. Mathematically this means that the output signal (out(t)) is a nonlinear functional (NLF) of the input signal (inp(t)), which may be assumed to be expandable into a functional power series (a so called Volterra series) e.g. of the type

(1)

$$out(t) = NLF[inp](t) = \int_0^t dt' \, h(t-t') \cdot inp(t') + \int_0^t dt' \int_0^{t'} dt'' \, h(t-t', t-t'') \cdot inp(t') \cdot inp(t'')$$

$$+ \int_0^t dt' \int_0^{t'} dt'' \int_0^{t''} dt''' \, h(t-t', t-t'', t-t''') \cdot inp(t') \cdot inp(t'') \cdot inp(t''') + ...(higher \quad order \quad terms)$$

In the important case of an input signal that is a superposition of two harmonic parts at frequencies $\omega_1$ and $\omega_2$ with complex amplitudes $V_1$ and $V_2$, this yields for the output signal in the (here interesting) spectral region of the input frequencies two contributions at $\omega_1$, $2 \cdot \omega_1 - \omega_2$, $\omega_2$, $2 \cdot \omega_2 - \omega_1$, namely

at $\omega_1$:   $V_1 H_1(\omega_1) + \dfrac{3}{4} V_1 V_1 V_1^* H_3(\omega_1, \omega_1, -\omega_1) + \dfrac{6}{4} V_1 V_2 V_2^* H_3(\omega_1, \omega_2, -\omega_2)$   (2)

at $2 \cdot \omega_1 - \omega_2$:   $\dfrac{3}{4} V_1 V_1 V_2^* H_3(\omega_1, \omega_1, -\omega_2)$   (3)

and similar expressions for the other contributions. H2 does not contribute because second order inter-modulation products are not generated in the spectral region considered here (if $\omega_1$ and $\omega_2$ not too far apart). The expression at $\omega_1$ includes a linear term amplified by H1 and two additional terms generated by H3 (corresponding to a third order nonlinearity), a self-compression term and a kind of cross-modulation term.

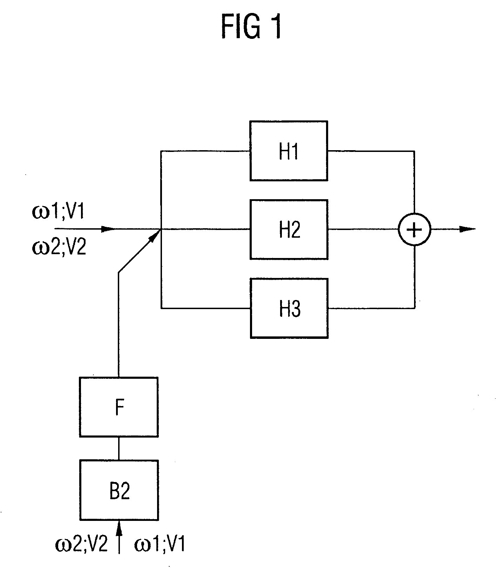

If a Filter F and a Volterra-operator B are introduced into the signal path according to figure 1, the output at $2 \cdot \omega_1 - \omega_2$ would be changed to

$$(3a)\quad \frac{3}{4}V_1V_1V_2^*H_3(\omega_1,\omega_1,-\omega_2)+\frac{1}{4}V_1V_1V_2^*B_2(\omega_1,-\omega_2)\cdot F(\omega_1-\omega_2)\cdot H_2(\omega_1,\omega_1-\omega_2)$$

This means that the two second order (quadratic) terms - described by B2 and H2) generate an additional inter-modulation product at $2\cdot\omega_1-\omega_2$. The operator B2 generates a mixed product at $\omega_1-\omega_2$ . This difference frequency is mixed with $\omega_1$ yielding a component at $2\cdot\omega_1-\omega_2$.

One might now be tempted to choose

$$(4)\quad F(\omega_1-\omega_2)=\frac{-3\cdot H_3(\omega_1,\omega_1,-\omega_2)}{B_2(\omega_1,-\omega_2)\cdot H_2(\omega_1,\omega_1-\omega_2)}$$

so that the resulting term at $2\cdot\omega_1-\omega_2$ would vanish identically. Apart from the fact that such a choice would assume an explicit knowledge of H2 and H3 this idea could turn out to be productive, if it would be amended in a suitable manner.

The current invention aims at utilizing the general idea to inject a pre-distorted envelope to cancel certain inter-modulation products in a similar way as indicated above.

To this end, the current invention introduces a pre-distortion in the base band and an additional filtering of the pre-distorted envelope by an adaptive, preferably digital, filter. The filter adaptation takes account of the fact that the nonlinear Volterra operators H2 and H3 are generally unknown and also dependent on temperature and power supply voltage. The injection of the pre-distorted envelope is preferably done with help of the bias input (BI) of the power amplifier (PA).

The filter adaptation process is preferably done by a digital control loop as e.g. shown in figure 2. The distorted output signal (HFS) of the power amplifier (PA) is extracted by a coupler (CP) at the output of the power amplifier (PA) and mixed into the base band by help of a mixer (MIX 2), converted into the digital domain by help of an analog-to-digital-converter (ADC), subsequently demodulated by a demodulator (DEM) and filtered by a transmission filter (TRXF). A difference signal between this "scaled" output signal and the output of the analog-to-digital-converter (ADC) is subsequently formed and transformed into the frequency domain, preferably by help of a fast fourier transform process (FFT), to calculate the spectrum E($\omega$).

The filter characteristic of the adaptive digital filter (DF) is now calculated on the basis of the spectrum E($\omega$) as shown in figure 2. The spectrum contains the inter-modulation products produced by the nonlinear characteristics of the power amplifier (PA).

If D($\omega$) is the distorted envelope, if D($\omega$) is assumed to be distorted by a quadratic (second order) nonlinearity, the spectrum of D($\omega$) is

$$(5)\quad D(\omega)=\int_{\omega}^{\omega_t}A(\omega')A^*(\omega-\omega')B_2(\omega',\omega-\omega')d\omega'+\int_{0}^{\omega'}A(\omega')A(\omega-\omega')B_2(\omega',\omega-\omega')d\omega'$$

Where A($\omega$) is a phasor, generated by evaluation of the amplitude spectrum of the modulated process at frequency $\omega$. In case the baseband signal is phase-modulated and amplitude-modulated at the same time, the total spectrum is calculated by a convolution of the distorted amplitude spectrum with the phase spectrum. $\omega_g$ is the cut-off frequency of the modulated process. For the spectrum E($\omega$) between $\omega_g$ and $2\omega_g$.

$$(6)\quad E(\omega)=a\cdot\int_{0}^{\omega-\omega_t}D(\omega')F(\omega')A(\omega-\omega')H_2(\omega',\omega-\omega')d\omega'+b\cdot IM(\omega)$$

holds in extension of the two-tone analysis given above.

IM(w) describes intermodulation products of the power amplifier (PA), e.g. generated by the cubic (i.e. third order) term H3 or by intermodulation products of the pre-amplifier (VGA). Factors a and b describe possible coefficients.

In reality, however, $IM(\omega)$, $H2(\omega)$ and $D(\omega)$ are unknown. Solely $E(\omega)$ is known from the measurement (extraction by coupler CP), difference forming and subsequent transformation into the frequency domain. Therefore, the last equation cannot be solved explicitly. The structure of this equation admits, however, a recursive procedure to determine the filter characteristic.

To this end, for a sufficient number of frequency values (control points) between $\omega$ and $\omega_g$, the associated values of F(k) (corresponding to $F(\omega_k-\omega_g)$) are determined. The number of necessary frequency values depends on the frequency response of the nonlinearity of the amplifier, here modelled by H2 and H3.

One preferably starts with the first control point (designated as F(0) here) above $\omega g$ and varies F(0) until $E(\omega_0)$ vanishes. The corresponding value of F(0) is stored. After that, $E(\omega_1)$ is considered and F(1) is varied until $E(\omega_1)$ vanishes, and so on. The remaining control points are determined in similarly. After each alteration of F(k), however, $E(\omega)$ has to be measured again. This is typical for most pre-distortion methods.

Since the nonlinear characteristic of the amplifier is not known explicitly an cannot be modelled with sufficient accuracy, the effect of the changed filter characteristic can only be determined by recent measurements.

An essential feature of the invention is the pre-distortion in the baseband domain. The signal is squared to generate a spectrum according to equation 5. The distorted baseband signal is then spectrally shaped by help of a adaptable digital filter, converted from the digital to the analog domain and is subsequently fed into the bias input (BI) of the power amplifier (PA). The signal, which is fed into the amplifier via the bias input (BI), generates - due to the quadratic nonlinearity of the amplifier - additional inter-modulation products of third order, which are superimposed with the inter-modulation products of third order originating from the cubic nonlinearity of the amplifier.

If certain conditions with respect to phase and amplitude (which we do not have to know explicitly because of the above described adaptation by a closed control loop) are met, a cancellation by destructive interference occurs, that leads to an efficient suppression (or compensation) of nonlinearities caused by the nonlinear characteristic of the amplifier.

For the purpose of adaptation of the filter characteristic, the output signal of the amplifier is extracted (i.e. coupled out, e.g. by a coupler) mixed into the base band and demodulated. Instead of a delay-time estimation, a method already described in European Patent Application No. 03016253.1, filed on July 17, 2003 and published as EP 1 499 012 on January 19, 2005, can be used. To this end, the output signal is demodulated and the modulating Bit(Chip)-sequence is regenerated. The demodulation is preferably done similarly to the procedure of the actual receiver. The algorithms therefore are well-known to the person skilled in the art.

After reconstruction of the data sequence from the transmitted signal, this sequence is processed (convolution) by the transmission filter (TRXF), which is e.g. a so called RRC in the case of UMTS). The convoluted signal is then compared to the sampled signal (1). By way of demodulation and subsequent convolution of the with the transmission filter, the base band signal is generated from the output signal. Therefore, the method according to the present invention is independent of delays in the modulator, the pre-amplifier (VGA) the power amplifier (PA) and so on.

## Claims

1. Method for generating a high frequency signal (HFS) from a base band signal (BBS), the method improving the quality of the high frequency signal by compensation of nonlinearities that might occur during the generation of the high frequency signal, the method comprising a digital control loop performed pre-distortion (PRED) of the base band signal.

2. Method according to claim 1 in which the pre-distortion of the base band signal is performed by a pre-distortion of the envelope of the base band signal together with a reconstruction of phase and amplitude of the base band signal by an adaptive digital filter (DF).

3. Method according to claim 2 in which the high frequency output signal of a power amplifier (PA) is used to calculate the filter characteristic of the adaptive digital filter (DF).

4. Method according to claim 3 in which the high frequency output signal is mixed into the base band and demodulated and in which a difference signal between this demodulated output signal and the base band signal is formed.

5. Method according to claim 4 in which a time synchronisation of the demodulated output signal with respect to the base band signal by way of a delay estimation is performed before forming the difference signal.

6. Method according to claim 4 in which the frequency spectrum of the difference signal is determined to support the calculation of the characteristic of the digital filter (DF).

7. Apparatus for generating a high frequency signal (HFS) from a base band signal (BBS), the apparatus comprising means for improving the quality of the high frequency signal by compensation of nonlinearities that might occur during the generation of the high frequency signal, these means comprising a digital control loop for performing a suitable pre-distortion (PRED) of the base band signal.

8. Apparatus according to claim 7 in which the pre-distortion of the base band signal is performed by a pre-distortion of the envelope of the base band signal together with a reconstruction of phase and amplitude of the base band signal by an adaptive digital filter (DF).

9. Apparatus according to claim 8 in which the high frequency output signal of a power amplifier (PA) is used to calculate the filter characteristic of the adaptive digital filter (DF).

10. Apparatus according to claim 9 in which the high frequency output signal is mixed into the base band and demodulated and in which a difference signal between this demodulated output signal and the base band signal is formed.

11. Apparatus according to claim 10 in which a time synchronisation of the demodulated output signal with respect to the base band signal by way of a delay estimation is performed before forming the difference signal.

12. Apparatus according to claim 11 in which the frequency spectrum of the difference signal is determined to support the calculation of the characteristic of the digital filter (DF).

# FIG 1

ω1;V1
ω2;V2

F

B2

ω2;V2 ⬆ ω1;V1

# FIG 2

**European Patent Office**

# EUROPEAN SEARCH REPORT

**Application Number**

EP 05 00 6969

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2001/051504 A1 (KUBO TOKURO ET AL) 13 December 2001 (2001-12-13) | 1-5,7-11 | H03F1/32 |
| Y | * paragraphs [0048] - [0051], [0060] - [0065]; figures 4,7 * | 6,12 | |
| Y | EP 1 429 453 A (NTT DOCOMO, INC) 16 June 2004 (2004-06-16) * paragraphs [0066] - [0070]; figures 21,22 * | 6,12 | |
| X | US 2003/117215 A1 (O'FLAHERTY MARTIN J ET AL) 26 June 2003 (2003-06-26) * paragraphs [0029] - [0038]; figure 3 * | 1-5,7-11 | |
| A | US 2004/021516 A1 (OISHI YASUYUKI ET AL) 5 February 2004 (2004-02-05) * paragraphs [0099] - [0101]; figure 12 * | 6,12 | |
| A | US 2003/223509 A1 (MA ZHENGXIANG) 4 December 2003 (2003-12-04) * paragraphs [0032] - [0029]; figures 2A,2B * | 1-12 | TECHNICAL FIELDS SEARCHED (Int.Cl.7) H03F |
| A | US 5 486 789 A (PALANDECH ET AL) 23 January 1996 (1996-01-23) * column 5, line 24 - column 6, line 22; figure 4 * | 1-12 | |

The present search report has been drawn up for all claims

| Place of search | Date of completion of the search | Examiner |
|---|---|---|
| The Hague | 9 September 2005 | Fedi, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 05 00 6969

This annex lists the patent family members relating to the patent documents cited in the above-mentioned European search report.
The members are as contained in the European Patent Office EDP file on
The European Patent Office is in no way liable for these particulars which are merely given for the purpose of information.

09-09-2005

| Patent document cited in search report | | Publication date | Patent family member(s) | | Publication date |
|---|---|---|---|---|---|
| US 2001051504 | A1 | 13-12-2001 | JP | 2001345718 A | 14-12-2001 |
| EP 1429453 | A | 16-06-2004 | CN | 1510832 A | 07-07-2004 |
| | | | EP | 1429453 A1 | 16-06-2004 |
| | | | JP | 2005065211 A | 10-03-2005 |
| | | | US | 2004116083 A1 | 17-06-2004 |
| US 2003117215 | A1 | 26-06-2003 | AU | 2002352421 A1 | 30-07-2003 |
| | | | CN | 1636314 A | 06-07-2005 |
| | | | EP | 1464112 A2 | 06-10-2004 |
| | | | WO | 03061114 A2 | 24-07-2003 |
| US 2004021516 | A1 | 05-02-2004 | WO | 02061938 A1 | 08-08-2002 |
| | | | US | 2004179524 A1 | 16-09-2004 |
| US 2003223509 | A1 | 04-12-2003 | NONE | | |
| US 5486789 | A | 23-01-1996 | EP | 0758501 A1 | 19-02-1997 |
| | | | FI | 964290 A | 25-10-1996 |
| | | | JP | 9512692 T | 16-12-1997 |
| | | | JP | 3534414 B2 | 07-06-2004 |
| | | | WO | 9627236 A1 | 06-09-1996 |

EPO FORM P0459

For more details about this annex : see Official Journal of the European Patent Office, No. 12/82

**EP 1 708 360 A1**

**Patent documents cited in the description**

- EP 03016253 A

- EP 1499012 A